# EUROPEAN PATENT APPLICATION

(11) **EP 4 608 091 A2**
(43) Date of publication of application: **27.08.2025**
(21) Application number: 25158593.1
(22) Date of filing: 18.02.2025
(51) Int. Cl.: H10D 84/01, H10D 30/01, H10D 30/43, H10D 30/00, H10D 84/03, H10D 84/85

(54) **SEMICONDUCTOR DEVICE INCLUDING FORKSHEET TRANSISTORS WITH ISOLATION WALL AND GATE CUT STRUCTURE THEREON**

(30) Priority: 26.02.2024 US 202463557940 P; 25.06.2024 US 202418753427
(71) Applicant: Samsung Electronics Co., Ltd., Suwon-si, Gyeonggi-do 16677 (KR)
(72) Inventor: SONG, Seung Min, San Jose, CA, 95134 (US); SEO, Kang-ill, San Jose, CA, 95134 (US)
(74) Representative: Kuhnen & Wacker Patent- und Rechtsanwaltsbüro PartG mbB

(57) **Abstract**

Provided is a semiconductor device which includes: a 1^{st} transistor including a 1^{st} channel structure extended in a 1^{st} direction, and a 1^{st} gate structure on the 1^{st} channel structure; a 2^{nd} transistor comprising a 2^{nd} channel structure extended in the 1^{st} direction, and a 2^{nd} gate structure on the 2^{nd} channel structure, the 2^{nd} transistor being disposed adjacent to the 1^{st} transistor in a 2^{nd} direction that horizontally intersects the 1^{st} direction; a 1^{st} isolation wall between the 1^{st} channel structure and the 2^{nd} channel structure; and a 1^{st} gate cut structure between the 1^{st} gate structure and the 2^{nd} gate structure on the 1^{st} isolation wall in a 3^{rd} direction that vertically intersects the 1^{st} direction and the 2^{nd} direction.

## Description

### BACKGROUND

### 1. Field

Apparatuses and methods consistent with the disclosure relate to a semiconductor device of a forksheet transistor structure including an isolation wall and a gate cut structure.

### 2. Description of Related Art

The nanosheet transistor was introduced to address shortcomings of the field-effect transistor (FinFET). The FinFET has one or more horizontally arranged vertical fin structures as a channel structure, in which three surfaces of each fin structure are surrounded by a gate structure, and the nanosheet transistor is characterized by one or more nanosheet layers vertically stacked on a substrate as a channel structure and a gate structure surrounding all four surfaces of each of the nanosheet layers. The nanosheet transistor is known to allow a better control of current and enable a higher device density than the FinFET in forming a semiconductor device. The nanosheet transistor is also referred to as gate-all-around (GAA) transistor, or as a multi-bridge channel field-effect transistor (MBCFET)

Recently, the nanosheet transistor has evolved into a forksheet transistor which enables further miniaturization of a semiconductor device. The forksheet transistor may take a form of a combination of two nanosheet transistors with an isolation wall therebetween as an insulation backbone. Nanosheet channel layers of each nanosheet transistor in the forksheet transistor may be formed at each side of the isolation wall and pass through a gate structure of the nanosheet transistor at each side of the isolation wall.

Researches have been active in improving performance of a semiconductor device including forksheet transistors and a manufacture process of the same.

Information disclosed in this background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

According to an aspect of example embodiments, there is provided a semiconductor device which may include: a 1^{st} transistor including a 1^{st} channel structure extended in a 1^{st} direction, and a 1^{st} gate structure on the 1^{st} channel structure; a 2^{nd} transistor comprising a 2^{nd} channel structure extended in the 1^{st} direction, and a 2^{nd} gate structure on the 2^{nd} channel structure, the 2^{nd} transistor being disposed adjacent to the 1^{st} transistor in a 2^{nd} direction that horizontally intersects the 1^{st} direction; a 1^{st} isolation wall between the 1^{st} channel structure and the 2^{nd} channel structure; and a 1^{st} gate cut structure between the 1^{st} gate structure and the 2^{nd} gate structure on the 1^{st} isolation wall in a 3^{rd} direction that vertically intersects the 1^{st} direction and the 2^{nd} direction

According to an aspect of example embodiments, a width of the 1^{st} gate cut structure may be greater than a width of the 1^{st} isolation wall in the 2^{nd} direction.

According to an aspect of example embodiments, there is provided a semiconductor device which may include: a 1^{st} transistor including a 1^{st} channel structure extended in a 1^{st} direction, and a 1^{st} gate structure on the 1^{st} channel structure; a 2^{nd} transistor including a 2^{nd} channel structure extended in the 1^{st} direction, and a 2^{nd} gate structure on the 2^{nd} channel structure, the 2^{nd} transistor being disposed adjacent to the 1^{st} transistor in a 2^{nd} direction that horizontally intersects the 1^{st} direction; a 1^{st} isolation wall between the 1^{st} channel structure and the 2^{nd} channel structure; and a 1^{st} gate cut structure between the 1^{st} gate structure and the 2^{nd} gate structure on the 1^{st} isolation wall in a 3^{rd} direction that vertically intersects the 1^{st} direction and the 2^{nd} direction, wherein the 1^{st} gate structure includes a 1^{st} work-function metal layer on the 1^{st} channel structure and a 1^{st} gate electrode on the 1^{st} work-function metal layer, and the 2^{nd} gate structure comprises a 2^{nd} work-function metal layer on the 2^{nd} channel structure and a 2^{nd} gate electrode on the 2^{nd} work-function metal layer, and wherein the 1^{st} gate cut structure contacts the 1^{st} isolation wall and at least one of the 1^{st} work-function metal layer and the 2^{nd} work-function metal layer.

According to an aspect of example embodiments, there is provided a semiconductor device which may include: a 1^{st} transistor including a 1^{st} channel structure and a 1^{st} gate structure on the 1^{st} channel structure, a 2^{nd} transistor disposed at a side of the 1^{st} transistor and comprising a 2^{nd} channel structure and a 2^{nd} gate structure on the 2^{nd} channel structure, and a 3^{rd} transistor disposed at a side of the 2^{nd} transistor and including a 3^{rd} channel structure and a 3^{rd} gate structure on the 3^{rd} channel structure; a 1^{st} isolation wall and a 1^{st} gate cut structure thereon between the 1^{st} gate structure and the 2^{nd} gate structure; and a 2^{nd} gate cut structure between the 2^{nd} gate structure and the 3^{rd} gate structure, wherein the 2^{nd} gate cut structure has a greater height than the 1^{st} gate cut structure in a direction in which the 1⁸¹ isolation wall is connected to the 1^{st} gate cut structure.

According to an aspect of example embodiments, there is provided a method of manufacturing a semiconductor device, which may include: providing a 1^{st} forksheet transistor structure including a 1^{st} channel structure and a 2^{nd} channel structure between which a 1^{st} isolation wall is disposed; forming a 1^{st} gate structure and a 2^{nd} gate structure on the 1^{st} channel structure and the 2^{nd} channel structure, respectively; and forming a 1^{st} gate cut structure on the 1^{st} isolation wall such that a width of the 1^{st} gate cut structure is greater than a width of the 1^{st} isolation wall.

### BRIEF DESCRIPTION OF DRAWINGS

Example embodiments of the disclosure will be more clearly understood from the following detailed description taken in conjunction with the accompanying drawings.
FIGS. 1A and 1B illustrate a semiconductor device including forksheet transistor structures including respective isolation walls, according to one or more embodiments.
FIGS. 2A and 2B illustrate a semiconductor device including forksheet transistor structures including isolation walls with gate cut structures thereon, according to one or more embodiments.
FIGS. 3A-3C illustrate a semiconductor device including forksheet transistor structures including isolation walls with wide gate cut structures thereon, according to one or more other embodiments.
FIGS. 4A and 4B illustrate a semiconductor device including forksheet transistor structures including isolation walls with misaligned wide gate cut structures thereon, according to one or more other embodiments.
FIGS. 5A and 5B illustrate a semiconductor device including forksheet transistor structures including isolation walls with misaligned wide gate cut structures thereon and a field gate cut structure, according to one or more other embodiments.
FIGS. 6A through 6H illustrate cross-section views of intermediate semiconductor devices after respective steps of manufacturing a semiconductor device including forksheet transistor structures including isolation walls with wide gate cut structures thereon and a field gate cut structure, according to one or more other embodiments.
FIGS. 7A and 7B illustrate a flowchart of a method of manufacturing a semiconductor device including forksheet transistor structures including isolation walls with wide gate cut structures thereon and a field gate cut structure, according to one or more other embodiments.
FIG. 8 is a schematic block diagram illustrating an electronic device including a semiconductor device including forksheet transistor structures including isolation walls with wide gate cut structures thereon, according to one or more embodiments.

### DETAILED DESCRIPTION

The embodiments of the disclosure described herein are example embodiments, and thus, the disclosure is not limited thereto, and may be realized in various other forms. Each of the embodiments provided in the following description is not excluded from being associated with one or more features of another example or another embodiment also provided herein or not provided herein but consistent with the disclosure. For example, even if matters described in a specific example or embodiment are not described in a different example or embodiment thereto, the matters may be understood as being related to or combined with the different example or embodiment, unless otherwise mentioned in descriptions thereof. In addition, it should be understood that all descriptions of principles, aspects, examples, and embodiments of the disclosure are intended to encompass structural and functional equivalents thereof. In addition, these equivalents should be understood as including not only currently well-known equivalents but also equivalents to be developed in the future, that is, all devices invented to perform the same functions regardless of the structures thereof. For example, active (channel) layers, sacrificial layers, and isolation layers described herein may take a different type or form as long as the disclosure can be applied thereto.

It will be understood that when an element, component, layer, pattern, structure, region, or so on (hereinafter collectively "element") of a semiconductor device is referred to as being "over," "above," "on," "below," "under," "beneath," "connected to" or "coupled to" another element the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present. Like numerals refer to like elements throughout this disclosure.

Spatially relative terms, such as "over," "above," "on," "upper," "below," "under," "beneath," "lower," "left," 2% "right," "lower-left," "lower-right," "upper-left," "upper-right," "central," "middle," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, an element described as "below" or "beneath" another element would then be oriented "above" the other element. Thus, the term "below" can encompass both an orientation of above and below. The semiconductor device may be otherwise oriented (rotated 90 degrees or at other orientations) and the spatially relative descriptors used herein interpreted accordingly. As another example, when elements referred to as a "left" element and a "right" element" may be a "right" element and a "left" element when a device or structure including these elements are differently oriented. Thus, in the descriptions herebelow, the "left" element and the "right" element may also be referred to as a "1^{st}" element or a "2^{nd}" element, respectively, as long as their structural relationship is clearly understood in the context of the descriptions. Similarly, the terms a "lower" element and an "upper" element may be respectively referred to as a "1^{st}" element and a "2^{nd}" element with necessary descriptions to distinguish the two elements.

It will be understood that, although the terms "1^{st}," "2^{nd}," "3^{rd}," "4^{th}," "5^{th}," "6^{th}," etc. may be used herein to describe various elements, these elements should not be limited by these terms. These terms are only used to distinguish one element from another element. Thus, a 1^{st} element discussed in the description of an embodiment could be termed a 2^{nd} element in a claim without departing from the teachings of the disclosure.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c. Herein, when a term "same" is used to compare a dimension of two or more elements, the term may cover a "substantially same" dimension.

It will be also understood that, even if a certain step or operation of manufacturing an apparatus or structure is described later than another step or operation, the step or operation may be performed later than the other step or operation unless the other step or operation is described as being performed after the step or operation.

Many embodiments are described herein with reference to cross-sectional views that are schematic illustrations of the embodiments (and intermediate structures). As such, variations from the shapes of the illustrations as a result, for example, of manufacturing techniques and/or tolerances, are to be expected. Thus, the embodiments should not be construed as limited to the particular shapes of regions illustrated herein but are to include deviations in shapes that result, for example, from manufacturing. Various regions illustrated in the figures are schematic in nature and their shapes are not intended to illustrate the actual shape of a region of a device and are not intended to limit the scope of the disclosure. Further, in the drawings, the sizes and relative sizes of layers and regions may be exaggerated for clarity.

For the sake of brevity, conventional elements, structures or layers of semiconductor devices including a nanosheet transistor or a forksheet transistor and materials forming the same may or may not be described in detail herein. For example, a certain isolation layer or structure of a semiconductor device and materials forming the same may be omitted herein when this layer or structure is not related to the novel features of the embodiments. Also, descriptions of materials forming well-known structural elements of a semiconductor device may be omitted herein when those materials are not relevant to the novel features of the embodiments. Herein, the term "isolation" pertains to electrical insulation or separation between structures, layers, components or regions in a corresponding device or structure.

Herebelow, various embodiments provide a structure of a semiconductor device including a plurality of forksheet transistors with an isolation wall and a gate cut structure.

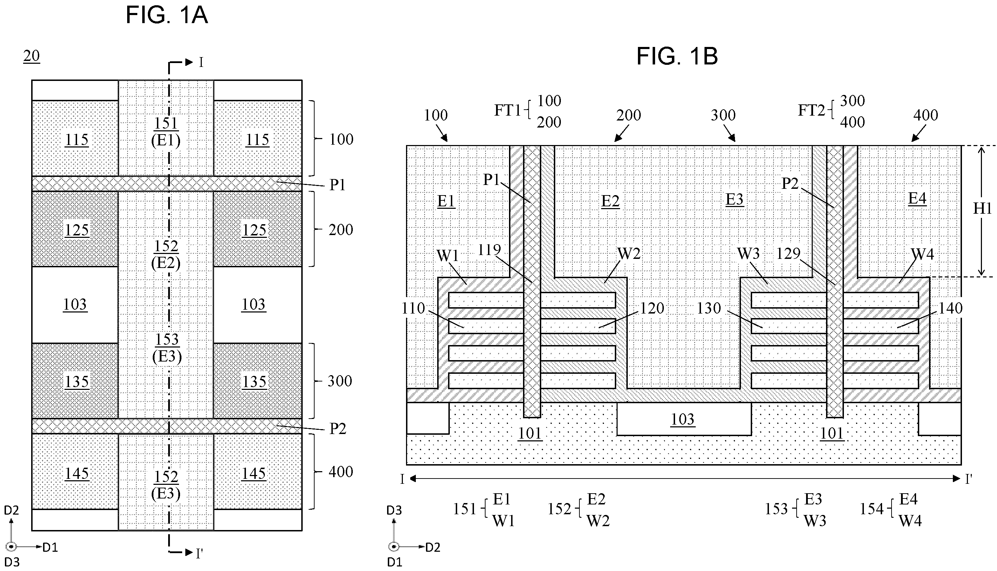

FIGS. 1A and 1B illustrate a semiconductor device including forksheet transistor structures including respective isolation walls, according to one or more embodiments.

FIG. 1A is a plan view of a semiconductor device 10 including forksheet transistor structures, and FIG. 1B is a cross-section view of the semiconductor device 10 shown in FIG. 1A taken along lines I-I' thereof.

As shown in FIGS. 1A and 1B, a D1 direction is a channel-length direction in which a current flows between two source/drain patterns (or source/drain regions) connected to each other through a channel structure, a D2 direction is a channel-width direction that intersects the D1 direction, and a D3 direction is a vertical direction that intersects the D1 and D2 directions both of which are horizontal directions.

Referring to FIGS. 1A and 1B, the semiconductor device 10 may include a 1^{st} forksheet transistor structure FT1 and a 2^{nd} forksheet transistor structure FT2 formed on a substrate 101 and arranged in the D2 direction. The 1^{st} forksheet transistor structure FT1 may include a 1^{st} transistor 100 and a 2^{nd} transistor 200 separated by a 1^{st} isolation wall 119, and the 2^{nd} forksheet transistor structure FT2 may include a 3^{rd} transistor 300 and a 4^{th} transistor 400 separated by a 2^{nd} isolation wall 129.

The 1^{st} isolation wall 119 may be extended in the D3 direction and penetrate into the substrate 101, and may also be extended in the D1 direction to separate channel structures, gate structures and source/drain patterns of the 1^{st} transistor 100 and the 2^{nd} transistor 200 as will be described later. Similarly, the 2^{nd} isolation wall 129 may be extended in the D3 direction and penetrate into the substrate 101, and may also be extended in the D1 direction to separate channel structures, gate structures and source/drain patterns of the 2^{nd} transistor 200 as will also be described later. A shallow trench isolation (STI) structure may be formed at an upper portion of the substrate 101 between the 1^{st} forksheet transistor structure FT1 and the FT2 to separate these two forksheet transistor structures at a substrate level. It is to be appreciated herein that the terms "separation" and "isolation" may be interchangeably used herein, and may refer to physical separation and/or electrical isolation.

Each of the transistors 100-400 forming the forksheet transistor structures FT1 and FT2 may be a nanosheet transistor, for example, including a plurality of channel layers or nanosheet layers as a channel structure thereof.

The 1^{st} transistor 100 may include 1^{st} channel layers 110 as a 1^{st} channel structure, a 1^{st} gate structure 151 surrounding the 1^{st} channel layers 110, and 1^{st} source/drain patterns 115 formed on the 1^{st} channel layers 110. The 1^{st} source/drain patterns 115 may be arranged in the D1 direction with the 1^{st} channel layer 110 therebetween. Similarly, the 2^{nd} transistor 200 may include 2^{nd} channel layers 120 as a 2^{nd} channel structure, a 2^{nd} gate structure 152 surrounding the 2^{nd} channel layers 120, and 2^{nd} source/drain patterns 125 formed on the 2^{nd} channel layers 120. The 2^{nd} source/drain patterns 125 may be arranged in the D1 direction with the 2^{nd} channel layers 120 therebetween. The 3^{rd} transistor 300 may include 3^{rd} channel layers 130 as a 3^{rd} channel structure, a 3^{rd} gate structure 153 surrounding the 3^{rd} channel layers 130, and 3^{rd} source/drain patterns 135 formed on the 3^{rd} channel layers 130. The 3^{rd} source/drain patterns 135 may be arranged in the D1 direction with the 3^{rd} channel layers 130 therebetween. Similarly, the 4^{th} transistor 400 may include 4^{th} channel layers 140 as a 4^{th} channel structure, a 4^{th} gate structure 154 surrounding the 4^{th} channel layers 140, and 4^{th} source/drain patterns 145 formed on the 4^{th} channel layers 140. The 4^{th} source/drain patterns 145 may be arranged in the D1 direction with the 4^{th} channel layers 140 therebetween.

The 1^{st} isolation wall 119 may include a protruding portion P1 at a level above a top surface of the 1^{st} channel structure and the 2^{nd} channel structure, and the 2^{nd} isolation wall 129 may include a protruding portion P2 at a level above a top surface of the 3^{rd} channel structure and the 4^{th} channel structure.

Thus, when the 1^{st} transistor 100 and the 2^{nd} transistor 200 are separated from each other by the 1^{st} isolation wall 119 to form the 1^{st} forksheet transistor structure FT1, the 1^{st} channel layers 110, the 1^{st} gate structure 151 and the 1^{st} source/drain patterns 115 may be separated from the 2^{nd} channel layers 120, the 2^{nd} gate structure 152 and the 2^{nd} source/drain patterns 125, respectively. Likewise, when the 3^{rd} transistor 300 and the 4^{th} transistor 200 are separated from each other by the 1^{st} isolation wall 119 to form the 2^{nd} forksheet transistor structure FT2, the 3^{rd} channel layers 110, the 3^{rd} gate structure 151 and the 3^{rd} source/drain patterns 115 may be separated from the 4^{th} channel layers 120, the 4^{th} gate structure 152 and the 4^{th} source/drain patterns 125, respectively.

The substrate 101 may be a silicon (Si) substrate although it may include other materials such as silicon germanium (SiGe), silicon carbide (SiC), not being limited thereto. The channel layers 110, 120, 130 and 140 may have been epitaxially grown from the substrate 101, and may be formed of or include the same material (e.g., Si) forming the substrate 101. The STI structure 103 formed in the substrate 101 may include an oxide material such as silicon oxide (e.g., SiO, SiO₂, etc.), not being limited thereto. The isolation walls 119 and 129 may each be formed of a dielectric material such as silicon nitride (SiN, SiCN, SiBCN, etc.,) not being limited thereto.

The source/drain patterns 115, 125, 135 and 145 may have been epitaxially grown from the respective channel layers 110, 120, 130 and 140 in a process of manufacturing the semiconductor device 10. The 1^{st} to 4^{th} source/drain patterns 115, 125, 135 and 145 may be formed of or include silicon (Si) or silicon germanium (SiGe), and doped with p-type impurities or n-type impurities. For example, in a case where the 1^{st} transistor 100 and the 4^{th} transistor 400 are each of a p-type, the 1^{st} source/drain patterns 115 and the 4^{th} source/drain patterns 145 may be formed of silicon germanium (SiGe) doped with boron (B), gallium (Ga) and/or indium (In). As another example, in a case where the 2^{nd} transistor 200 and the 3^{rd} transistor 300 sharing a gate structure are each of an n-type, the 2^{nd} source/drain patterns 125 and the 3^{rd} source/drain patterns 135 may be formed of silicon (Si) doped with phosphorus (p), arsenic (As) and/or antimony (Sb).

Each of the gate structures 151, 152, 153 and 154 may include a work-function metal layer and a gate electrode. For example, the 1^{st} gate structure 151 of the 1^{st} transistor 100 may include a 1^{st} work-function metal layer W1 surrounding the 1^{st} channel layers 110 and a 1^{st} gate electrode E1 on the 1^{st} work-function metal layer W1. The 2^{nd} gate structure 152 of the 2^{nd} transistor 200 may include a 2^{nd} work-function metal layer W2 surrounding the 2^{nd} channel layers 120, and a 2^{nd} gate electrode E2 on the 2^{nd} work-function metal layer W2. The 3^{rd} gate structure 153 of the 3^{rd} transistor 300 may include a 3^{rd} work-function metal layer W3 surrounding the 3^{rd} channel layers 130, and a 3^{rd} gate electrode E3 on the 3^{rd} work-function metal layer W3. The 4^{th} gate structure 154 of the 4^{th} transistor 400 may include a 4^{th} work-function metal layer W4 surrounding the 4^{th} channel layers 140, and a 4^{th} gate electrode E4 on the 4^{th} work-function metal layer W4. A gate dielectric layer may be formed between the work-function metal layers W1-W4 and the gate electrodes E1-E4, respectively.

The work-function metal layers W1-W4 may each be formed of a metal such as copper (Cu), aluminum (Al), titanium (Ti), tantalum (Ta), tungsten (W), cobalt (Co), TiN, WN, TiAl, TiAlN, TaN, TiC, TaC, TiAlC, TaCN, TaSiN, and/or a combination thereof, not being limited thereto. However, the work-function metal layers W1-W4 may be formed of different materials among the above-listed materials depending on a polarity type of transistor that each of the work-function metal layers W1-W4 forms or a gate threshold voltage for each of the gate structures 151-154. The gate electrodes E1-E4 may each be formed of Cu, W, Al, Ruthenium (Ru), molybdenum (Mo), Co, and/or a combination thereof, not being limited thereto.

As will be described later, the gate structures 151-154 respectively including the work-function metal layers W1-W4 are formed after the formation of the isolation walls 119 and 129 in manufacturing the semiconductor device 10, and thus, the work-function metal layers W1 and W2 may be formed on side surfaces of the 1^{st} isolation wall 119, respectively, and the work-function metal layers W3 and W4 may be formed on side surfaces of the 2^{nd} isolation wall 129, respectively.

In the embodiment shown in FIGS. 1A and 1B, the 2^{nd} work-function metal layer W2 and the 3^{rd} work-function metal layer W3 may be connected to each other at a position between the 2^{nd} transistor 200 and the 3^{rd} transistor 300, and the 2^{nd} gate electrode E2 and the 3^{rd} gate electrode E3 may be a single gate electrode structure. This may be at least because the two transistors 200 and 300 are of the same type, e.g., p-type or n-type, or have the same gate threshold voltage, even if the two transistors 200 and 300 are included in different forksheet transistor structures FT1 and FT2, respectively.

In contrast, the 1^{st} transistor 100 and the 2^{nd} transistor 200 of the 1^{st} forksheet transistor structure FT1 may be separated from each other by the 1^{st} isolation wall 119, and thus, the 1^{st} work-function metal layer W1 and the 2^{nd} work-function metal layer W2 may also be separated from each other by the 1^{st} isolation wall 119. This may be at least because the two transistors 100 and 200 are of different types, e.g., p-type and n-type, respectively, or vice versa, or have different gate threshold voltages, even if the two transistors 100 and 200 are included in the same 1^{st} forksheet transistor structure FT1. Likewise for the same reasons, the 3^{rd} transistor 300 and the 4^{th} transistor 400 of the 2^{nd} forksheet transistor structure FT2 may be separated from each other by the 2^{nd} isolation wall 129, and thus, the 3^{rd} work-function metal layer W3 and the 4^{th} work-function metal layer W4 may also be separated from each other by the 2^{nd} isolation wall 129. However, even if the two transistors 100 and 200 or 300 and 400 are of the same type and have the same gate threshold voltage, a circuit design of the semiconductor device 10 may require isolation of the two transistors, according to one or more other embodiments.

In the meantime, in the forksheet transistor structure FT1 and FT2, each of the protruding portions P1 and P2 of the isolation walls 119 and 129 may have a height H1 which may be sufficiently high enough to isolate the transistors T1 and T2 and isolate the transistors T3 and T4, respectively. However, in a manufacturing process, the semiconductor device 10 may not be formed to have the sufficient height H1 for the protruding portions P1 and P2 of the isolation walls 119 and 129 that can clearly isolate the two transistors at both sides thereof, in which case the gate structures 151 and 152 or the gate structures 153 and 154 may be connected in violation of an original design for the semiconductor device 10. This short height of the protruding portions of the isolation walls may occur because of a manufacturing difficulty in the isolation walls having a high aspect ratio, considerations of forming other structural elements for the forksheet transistor structures such as contacts, metal lines and vias above the semiconductor device, not being limited thereto. Thus, an additional gate cut structure may be formed on the isolation walls, according to one or more following embodiments.

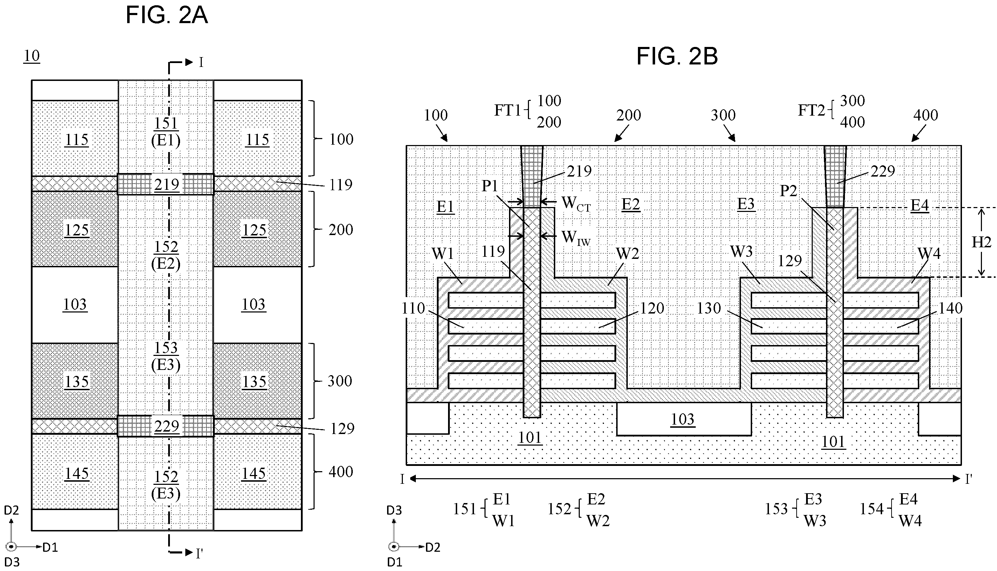

FIGS. 2A and 2B illustrate a semiconductor device including forksheet transistor structures including isolation walls with gate cut structures thereon, according to one or more embodiments.

Referring to FIGS. 2A and 2B, a semiconductor device 20 may have the same structural elements as those of the semiconductor device 10 of FIGS. 1A and 1B except that, in the semiconductor device 20, protruding portions P1 and P2 of the 1^{st} isolation wall 119 and the 2^{nd} isolation wall 129 have a smaller height H2, and instead, a 1^{st} gate cut structure 219 and a 2^{nd} gate cut structure 229 are formed on the 1^{st} isolation wall 119 and the 2^{nd} isolation wall 129, respectively.

The gate cut structures 219 and 229 may each be formed of silicon nitride (SiN, SICN, SIBCN, etc.), not being limited thereto, which may be the same material as or a different material from that forming the isolation walls 119 and 129. However, as will be described later, the gate cut structures 219 and 229 may be formed after the isolation walls 119 and 129 are formed in manufacturing the 3D-stacked semiconductor device 20, and thus, there may be a connection surface or interface therebetween.

Moreover, also as will be described later, the gate cut structures 219 and 229 may be formed after the gate structures 151-154 respectively including the work-function metal layers W1-W4 are formed, and thus, the work-function metal layers W1 and W2 may not be formed on side surfaces of the 1^{st} gate cut structure 219, and the work-function metal layers W3 and W4 may not be formed on side surfaces of the 2^{nd} gate cut structure 229.

Thus, even if the isolation walls 119 and 129 are formed not to be sufficiently high, the gate cut structures 219 and 229 formed thereon may clearly isolate the gate structures 151 and 152 or 153 and 154, respectively.

In the meantime, when the gate cut structures 219 and 229 are formed by etching an initial gate electrode prior to being divided into the gate electrodes E1-E4, the etching operation may not be accurate enough to form gate cut recesses, in which the gate cut structures 219 and 229 are to be formed, to be aligned with the underlying isolation walls 119 and 129, respectively. Thus, at least one of the gate cut recesses may be misaligned with the corresponding one of the isolation walls 119 and 129 in the D2 direction. Accordingly, at least one of the gate cut structures 219 and 229 filled in the gate cut recesses, respectively, may be misaligned with the corresponding one of the isolation walls 119 and 129, thereby isolation between the gate structures 151 and 152 and/or between the gate structures 153 and 154 may be broken to fail the functionality of the semiconductor device 10.

This misalignment may be more likely to occur when a width W_{CT} of each of the gate cut recesses or each of the gate cut structure 219 and 229 is equal to or smaller than a width W_{IW} of each of the protruding portion P1 of the 1^{st} isolation wall 119 and the protruding portion P2 of the 2^{nd} isolation wall 129 in the D2 direction. Here, the remaining portion of each of the isolation walls 119 and 129 may also have the same width W_{IW}. For example, the width W_{IW} may range from about 15 nm to about 20 nm, not being limited thereto. In other embodiments, the width W_{IW} may be less than 15 nm. In some embodiments, the width W_{IW} may be more than 20 nm.

The following embodiments may address the foregoing isolation failure by a gate cut structure on an isolation wall in a semiconductor device including forksheet transistor structures.

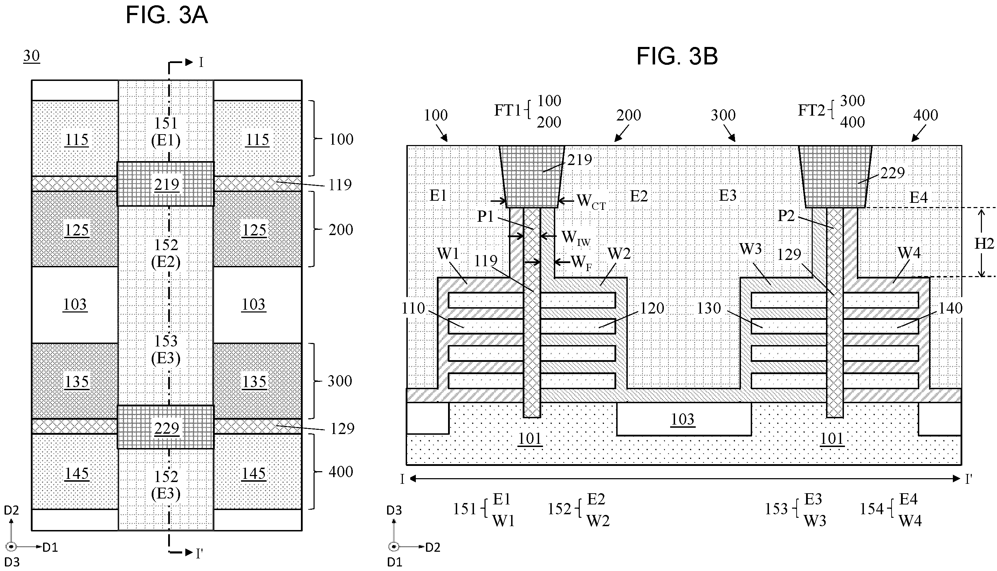

FIGS. 3A-3C illustrate a semiconductor device including forksheet transistor structures including isolation walls with wide gate cut structures thereon, according to one or more other embodiments.

Referring to FIGS. 3A and 3B, a semiconductor device 30 may have the same structural elements as those of the semiconductor device 20 of FIGS. 2A and 2B except that, in the semiconductor device 30, a width W_{CT} of each of the gate cut structures 219 and 229 may be greater than the width W_{IW} of each of the protruding portion P1 of the 1^{st} isolation wall 119 and the protruding portion P2 of the 2^{nd} isolation wall 129. However, the disclosure is not limited thereto. According to one or more other embodiments, the width W_{CT} may be greater than a sum of the width W_{IW} and at least one of a width W_{F} of an upper portion of the 1^{st} work-function metal layer W1 and the same width W_{F} of an upper portion of the 2^{nd} work-function metal layer W2. Here, the widths of the upper portions of the work-function metal layers W1-W4 may be the same.

According to one or more other embodiments, the width W_{CT} of each of the gate cut structures 219 and 229 may be greater than or equal to a sum of the width W_{IW}, a width W_{F} of an upper portion of the 1^{st} work-function metal layer W1, and the same width W_{F} of an upper portion of the 2^{nd} work-function metal layer W2.

Here, the width W_{F} of the upper portion of each of the 1^{st} work-function metal layer W1 and the 2^{nd} work-function metal layer W2 may be the same as widths of the other portions of each of the 1^{st} work-function metal layer W1 and the 2^{nd} work-function metal layer W2, for example, a width of a portion between two adjacent channel layers 110 or 120 in the D3 direction.

Further, top surfaces of the 1^{st} isolation wall 119, the upper portion of the 1^{st} work-function metal layer W1, and the upper portion of the 2^{nd} work-function metal layer W2 may be horizontally aligned or coplanar, and these top surfaces may all contact a bottom surface of the 1^{st} gate cut structure 219. Similarly, top surfaces of the 1^{st} isolation wall 119, the upper portion of the 1^{st} work-function metal layer W1, and the upper portion of the 2^{nd} work-function metal layer W2 may be horizontally aligned or coplanar, and these top surfaces may all contact a bottom surface of the 1^{st} gate cut structure 219.

As each of the gate cut structures 219 and 229 has the greater width W_{CT} as described above, an alignment margin in the D2 direction may be increased in the semiconductor device 30, and thus, a risk of misalignment between the 1^{st} gate cut structure 219 and the 1^{st} isolation wall 119 and misalignment between the 2^{nd} gate cut structure 229 and the 2^{nd} isolation wall 129 may be reduced. Thus, clear isolation between the gate structures 151 and 152 and/or between the gate structures 153 and 154 may be implemented within the increased alignment margin to prevent isolation failure in the semiconductor device 30.

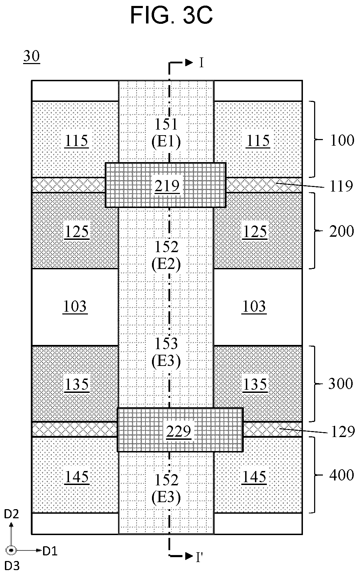

In the meantime, the semiconductor device 30 may be formed such that the gate cut structures 219 and 229 have increased lengths in the D1 direction as shown in FIG. 3C. Thus, the semiconductor device 30 may be able to provide an alignment margin in the D1 direction between the gate cut structures 219 and 229 with respect to the isolation walls 119 and 129, respectively, and manufacturing simplicity may be further increased over the semiconductor device 20.

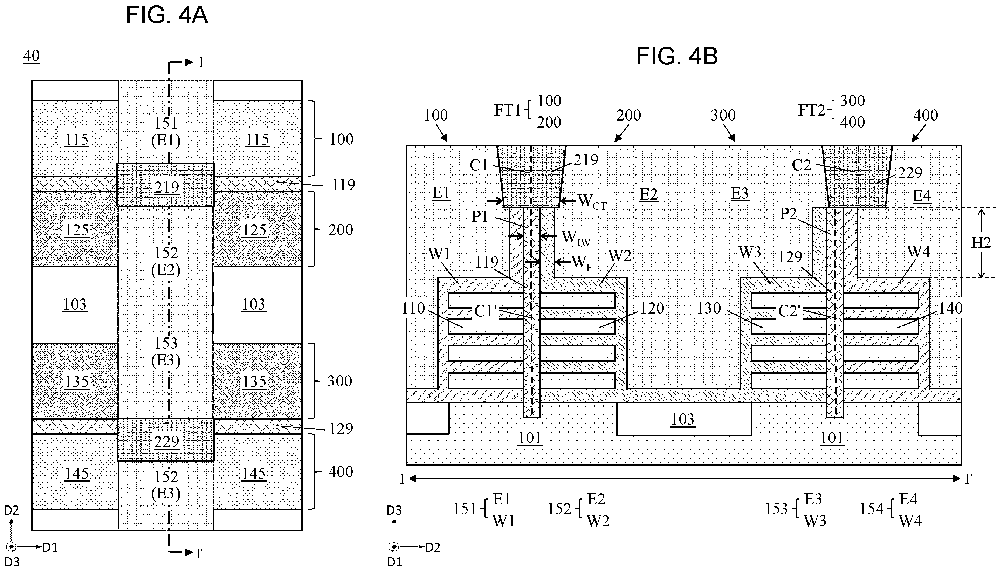

FIGS. 4A and 4B illustrate a semiconductor device including forksheet transistor structures including isolation walls with misaligned wide gate cut structures thereon, according to one or more other embodiments.

Referring to FIGS. 4A and 4B, a semiconductor device 40 may have the same structural elements as those of the semiconductor device 30 of FIGS. 3A and 3B except that, in the semiconductor device 40, the 2^{nd} gate cut structure 229 is misaligned with the 2^{nd} isolation wall 129 thereon within an alignment margin.

Compared to the semiconductor device 30, the semiconductor device 40 is formed such that, although a virtual vertical centerline C1 of the 1^{st} gate cut structure 219 is aligned with a virtual vertical centerline C1' of the 1^{st} isolation wall 119, a virtual vertical centerline C2 of the 2^{nd} gate cut structure 229 is not aligned with a virtual vertical centerline C2' of the 2^{nd} isolation wall 129. Still, however, the 2^{nd} gate cut structure 229 may be formed on the 2^{nd} isolation wall 219 within an increased alignment margin. Thus, the 2^{nd} gate cut structure 229 may be connected to the 2^{nd} isolation wall 129 without causing isolation failure between the 3^{rd} gate electrode E3 and the 4^{th} gate electrode E4.

In the meantime, the above embodiments provide the semiconductor devices in which the 2^{nd} transistor 200 and the 3^{rd} transistor 300 share a gate structure or gate structures thereof are connected. However, the semiconductor device 30 may be configured such that the 2^{nd} gate structure 152 of the 2^{nd} transistor 200 and the 3^{rd} gate structure 153 of the 3^{rd} transistor 300 are separated from each other.

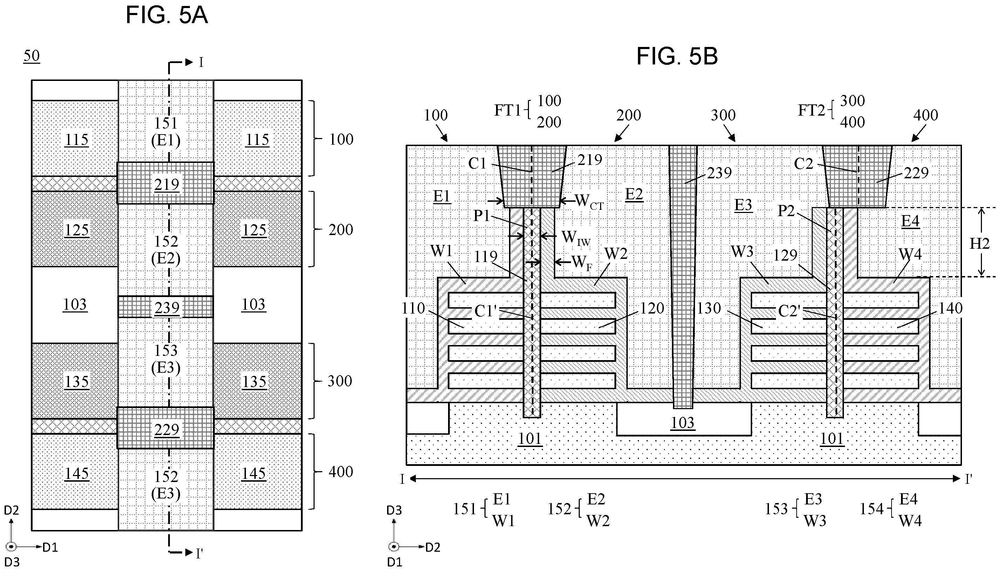

FIGS. 5A and 5B illustrate a semiconductor device including forksheet transistor structures including isolation walls with misaligned wide gate cut structures thereon and a field gate cut structure, according to one or more other embodiments.

Referring to FIGS. 5A and 5B, a semiconductor device 50 may have the same structural elements as those of the semiconductor device 40 of FIGS. 4A and 4B except that, in the semiconductor device 50, a 3^{rd} gate cut structure is formed to separate the 2^{nd} gate structure 152 and the 3^{rd} gate structure 153. For example, the 2^{nd} work-function metal layer W2 and the 2^{nd} gate electrode E2 may be isolated from the 3^{rd} work-function metal layer W3 and the 3^{rd} gate electrode E3, respectively, by the 3^{rd} gate cut structure 239 which may also be referred to as a field gate cut structure.

The 3^{rd} gate cut structure 239 may be extended in the D3 direction from the STI structure to a top surface of the 2^{nd} gate electrode E2 to have a greater height than each of the 1^{st} gate cut structure 219, the 2^{nd} gate cut structure 229, the 1^{st} isolation wall 119, and the 2^{nd} isolation wall 129.

The 3^{rd} isolation wall 239 may be formed to separate the two transistors 200 and 300 even if the two transistors 200 and 300 are of the same type and have the same gate threshold voltage in a case where a circuit design of the semiconductor device 50 may require isolation of the two transistors. However, according to one or more other embodiments, the two transistors 200 and 300 may be of different same types, e.g., p-type and n-type or vice versa, or have different gate threshold voltages regardless of the polarity thereof, which requires the 3^{rd} isolation wall 239 to separate the two transistors 200 and 300.

Herebelow, a method of manufacturing a semiconductor device including formed of forksheet transistor structures including isolation walls and gate cut structures thereon is provided.

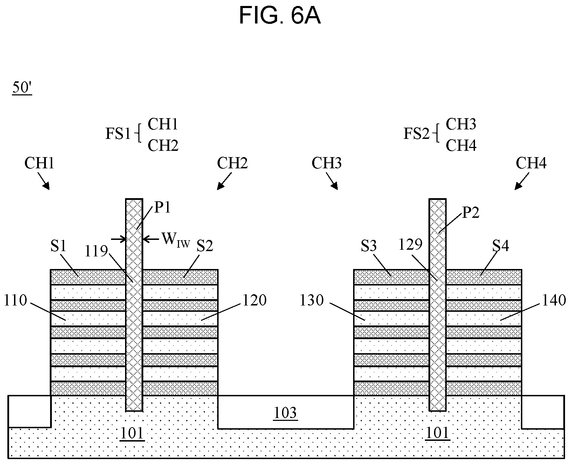

FIGS. 6A through 6H illustrate cross-section views of intermediate semiconductor devices after respective steps of manufacturing a semiconductor device including forksheet transistor structures including isolation walls with wide gate cut structures thereon and a field gate cut structure, according to one or more other embodiments.

The semiconductor device manufactured in reference to FIGS. 6A-6H may be or correspond to the semiconductor device 50 shown in FIGS. 5A and 5B, and thus, the cross-section view of each of the intermediate semiconductor devices shown in FIGS. 6A-6H may correspond to that shown in FIG. 5B. Thus, duplicate descriptions about the same structural elements described above in reference to FIGS. 5A and 5B may be omitted, and the same reference characters or numerals may be used herebelow for brevity purposes.

Referring to FIG. 6A, a 1^{st} forksheet structure FS1 and a 2^{nd} forksheet structure FS2 formed on a substrate 101 may be provided to form an intermediate semiconductor device 50', in which the 1^{st} forksheet structure FS1 includes a 1^{st} channel stack CH1 and a 2^{nd} channel stack CH2, and the 2^{nd} forksheet structure FS2 includes a 3^{rd} channel stack CH3 and a 4^{th} channel stack CH4. The 1^{st} forksheet structure FS1 and the 2^{nd} forksheet structure FS2 may be separated by an STI structure 103 on a substrate level.

The 1st to 4^{th} channel stacks CH1-CH4 may be obtained by dividing an initial channel stack formed through, for example, epitaxially growing a plurality of nanosheet layers from the substrate 101 in the D3 direction. The epitaxy performed in this step may include molecular beam epitaxy (MBE), vapor-phase epitaxy (VPE), etc., not being limited thereto, such that a sacrificial layer of silicon germanium (SiGe) and an channel layer of silicon (Si) are grown one after another in an alternating manner on the substrate 101 until a desired number of layers are obtained for an initial channel stack. The initial channel stack then may be divided into the 1^{st} to 4^{th} channel stacks CH1-CH4 through, for example, photolithography, masking and etching operations.

Then, an STI structure 103 may be formed to separate the 1^{st} and 2^{nd} channel stacks CH1 and CH2 from the 3^{rd} and 4^{th} channel stack CH3 and CH4. Further, a 1^{st} isolation wall 119 may be formed between the 1^{st} channel stack CH1 and the 2^{nd} channel stack CH2 to penetrate into the substrate 101 and have a protruding portion P1 formed above top surfaces of the 1^{st} and 2^{nd} channel stacks CH1 and CH2. Similarly, a 2^{nd} isolation wall 129 may be formed between the 3^{rd} channel stack CH3 and the 4^{th} channel stack CH4 to penetrate into the substrate 101 and have a protruding portion P2 formed above top surfaces of the 3^{rd} and 4^{th} channel stacks CH3 and CH4. Each of the isolation walls 119 and 129 may have a width W_{IW} in the D2 direction.

Thus, the 1^{st} channel stack CH1 may be formed to include a plurality of sacrificial layers S1 and channel layers 110 alternatingly stacked on the substrate 101 and contacting a left side surface of the 1^{st} isolation wall 119, and the 2^{nd} channel stack CH2 may be formed to include a plurality of sacrificial layers S2 and channel layers 120 alternatingly stacked on the substrate 101 and contacting a right side surface of the 1^{st} isolation wall 119. Similarly, the 3^{rd} channel stack CH3 may be formed to include a plurality of sacrificial layers S3 and channel layers 130 alternatingly stacked on the substrate 101 and contacting a left side surface of the 2^{nd} isolation wall 129, and the 4^{th} channel stack CH4 may be formed to include a plurality of sacrificial layers S4 and channel layers 140 alternatingly stacked on the substrate 101 and contacting a right side surface of the 2^{nd} isolation wall 129.

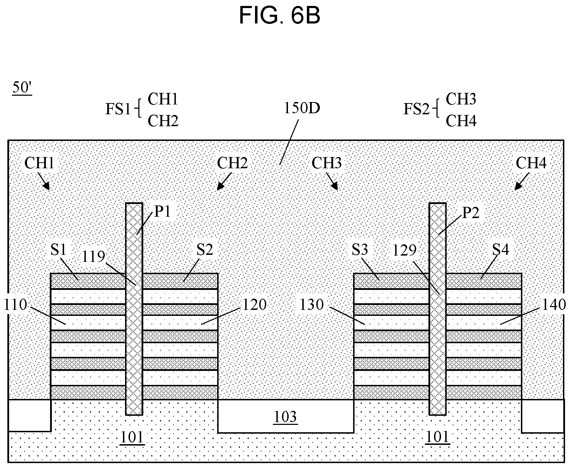

Referring to FIG. 6B, a dummy gate structure 150D may be formed to surround the forksheet structures FS1 and FS2 including the channel stacks CH1-CH4, followed by planarization of a top surface thereof.

The dummy gate structure 150D may be formed through, for example, depositing polycrystalline silicon (p-Si) or amorphous silicon (a-Si) on the forksheet structures FS1 and FS2 including the channel stacks CH1-CH4. The deposition may be physical vapor deposition (PVD), chemical vapor deposition (CVD), plasma-enhanced chemical vapor deposition (PECVD), or a combination thereof, not being limited thereto. Further, a planarization such as chemical-mechanical polishing (CMP) operation may be performed on the dummy gate structure 150D such that the top surface of the dummy gate structure 150D is at a level above top surfaces of the isolation walls 119 and 129.

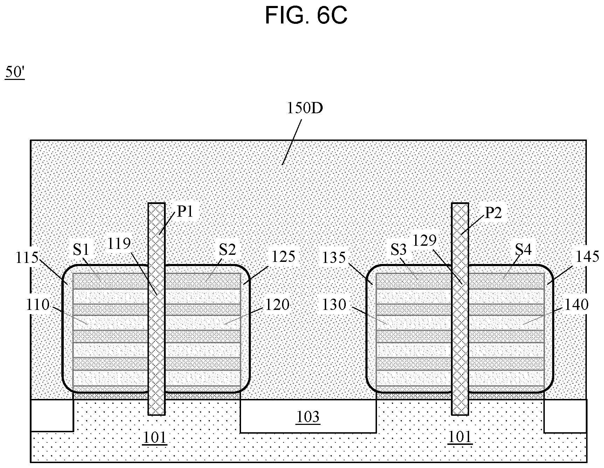

Referring to FIG. 6C, the 1^{st} to 4^{th} source/drain patterns 115, 125, 135 and 145 may be formed on both sides of the 1^{st} to 4^{th} channel stacks CH1-CH4 in the D1 direction.

For example, the 1^{st} source/drain patterns 115 may be epitaxially grown from the channel layers 110 of the 1^{st} channel stack CH1, the 2^{nd} source/drain patterns 125 may be epitaxially grown from the channel layers 120 of the 2^{nd} channel stack CH2, the 3^{rd} source/drain patterns 135 may be epitaxially grown from the channel layers 120 of the 3^{rd} channel stack CH3, and the 4^{th} source/drain patterns 145 may be epitaxially grown from the channel layers 140 of the 4^{th} channel stack CH4.

The 1^{st} to 4^{th} source/drain patterns 115, 125, 135 and 145 may each be formed of silicon (Si) or silicon germanium (SiGe), and may be doped in-situ with p-type impurities (e.g., boron (B), gallium (Ga), or indium (In)) or n-type impurities (e.g., phosphorus (P), arsenic (As), or antimony (Sb)).

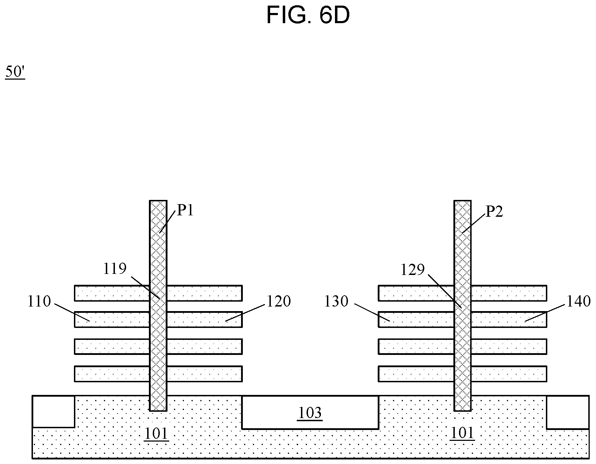

Referring to FIG. 6D, the dummy gate structure 150D formed in the previous step (FIG. 6B) may be selectively removed along with the sacrificial layers S1-S4 of the channel stacks CH1-CH4 through dry etching (e.g., reactive ion etching) or wet etching (e.g., chemical oxide removal). As the dummy gate structure 150D and the sacrificial layers S1-S4 are removed, the channel layers 110-140 may be released for subsequent operation of forming gate structures thereon.

It is to be appreciated that, from FIG. 7D, the source/drain patterns 115, 125, 135 and 145 are not shown as they may obscure formation of gate structures and gate cut structures.

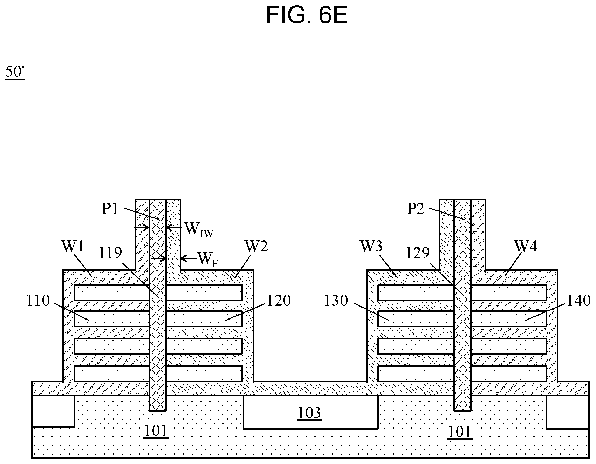

Referring to FIG. 6E, spaces provided by the removal of the dummy gate structure 150D and the sacrificial layers S1-S4 may be filled in with 1^{st} to 4^{th} work-function metal layers W1-W4 for respective 1^{st} to 4^{th} gate structures 151-154 through, for example, atomic layer deposition (ALD), plasma-enhanced atomic layer deposition (PEALD), CVD, PVD, PECVD, a combination thereof, not being limited thereto. Prior to the formation of the work-function metal layers W1-W4, a gate dielectric layer may be formed to surround the channel layers 110-140.

In forming the work-function metal layers W1-W4, a same work-function metal layer may be formed to surround the 2^{nd} channel layers 120 and the 3^{rd} channel layers 130. In other words, the 2^{nd} work-function metal layer W2 and the 3^{rd} work-function metal layer may be the same work-function metal layer including the same material or material composition. This may be at least because a transistor to be formed of the 2^{nd} work-function metal layer W2 and a transistor to be formed of the 3^{rd} work-function metal layer W3 may be of the same type or have the same gate threshold voltage.

Further, an upper portion of the 1^{st} work-function metal layer W1 and an upper portion of the 2^{nd} work-function metal layer W2 may be formed on a left side surface and a right side surface of the protruding portion P1 of the 1^{st} isolation wall 119, respectively. Similarly, an upper portion of the 3^{rd} work-function metal layer W3 and an upper portion of the 4^{th} work-function metal layer W4 may be formed on a left side surface and a right side surface of the protruding portion P2 of the 2^{nd} isolation wall 129, respectively.

The work-function metal layers W1-W4 may also be formed such that top surfaces of the 1^{st} isolation wall 119, the upper portion of the 1^{st} work-function metal layer W1, and the upper portion of the 2^{nd} work-function metal layer W2 are horizontally aligned or coplanar, and top surfaces of the 1^{st} isolation wall 119, the upper portion of the 1^{st} work-function metal layer W1, and the upper portion of the 2^{nd} work-function metal layer W2 are horizontally aligned or coplanar.

Each of the upper portions of the work-function metal layers W1-W4 may have a width W_{F} in the D2 direction, which may be the same as the other portions of each of the work-function metal layers W1-W4, for example, a width of a portion between two adjacent channel layers 110 or 120 in the D3 direction.

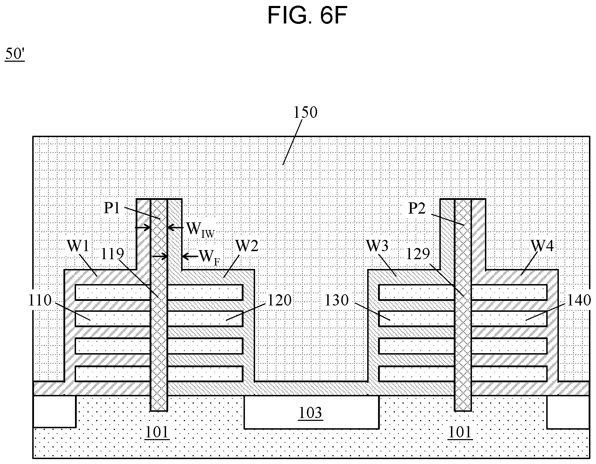

Referring to FIG. 6F, an initial gate electrode 150 may be formed on the intermediate semiconductor device 50' obtained in the previous step, followed by planarization of a top surface thereof.

The formation of the initial gate electrode 150 may be performed through, for example, PVD, CVD, PECVD, a combination thereof, not being limited thereto, and a CMP operation may be performed on the top surface thereof. After the CMP operation, a top surface of the initial gate electrode 150 may be at a level higher than top surfaces of the isolation wall 119, 129 and the upper portions of the work-function metal layers W1-W4.

The initial gate electrode 150 may be formed of a material such as Cu, Al, W, Ru, Mo, Co, or a combination thereof, not being limited thereto.

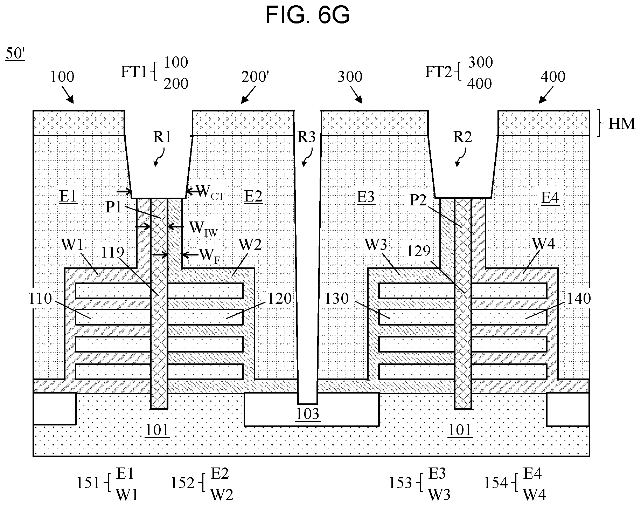

Referring to FIG. 6G, hard mask patterns HM may be formed on the top surface of the initial gate electrode 150 through, for example, photolithography, not being limited thereto, and the initial gate electrode 150 may be patterned based on the hard mask patterns HM to expose the isolation walls 119, 129 and an STI structure 103 in the substrate 101 between the 2^{nd} and 3^{rd} channel stacks CH2 and CH3 through 1^{st} to 3^{rd} recesses R1-R3, respectively.

Based on the hard mask patterns HM, the initial gate electrode 150 may be patterned to form the 1^{st} and 2^{nd} recesses R1 and R2 having sufficient widths W_{CT} to easily expose the 1^{st} and 2^{nd} isolation walls 119 and 129, respectively, thereby facilitating formation of gate cut structures thereon in a next step. For example, the 1^{st} recess R1 may have a width W_{CT} which may be greater than a sum of a width W_{IW} of the protruding portion P1 of the isolation wall 119 or 129, a width W_{F} of the upper portion of the 1^{st} work-function metal layer W1, and the same width W_{F} of the upper portion of the 2^{nd} work-function metal layer W2.

Thus, the 1^{st} recess R1 may expose a top surface of the 1^{st} isolation wall 119 and top surfaces of the 1^{st} and 2^{nd} work-function metal layers W1 and W2 formed on side surfaces of the 1^{st} isolation wall 119, and the 2^{nd} recess R2 may expose a top surface of the 2^{nd} isolation wall 129 and top surfaces of the 3^{rd} and 4^{th} work-function metal layers W3 and W4 formed on side surfaces of the 2^{nd} isolation wall 129. Further, the hard mask patterns HM may be patterned such that the subsequent patterning operation may form the 3^{rd} recess R3 exposing the STI structure 103 in the substrate 101 between the 2^{nd} and 3^{rd} channel stacks CH2 and CH3.

By the pattering operation in this step, the initial gate electrode 150 may be patterned into 1^{st} to 4^{th} gate structures 151-154 and the side surfaces of the isolation walls 119 and 129, respectively. The 1^{st} to 4^{th} gate structures 151-154 may now be formed respectively include the 1^{st} to 4^{th} gate electrodes E1-E4 and the 1^{st} to 4^{th} work-function metal layers W1-W4 formed on the channel layers 110, 120, 130, 140. Thus, the intermediate semiconductor device 50' may take a form of a semiconductor device of two forksheet transistor structures FT1 and FT2 respectively including four nanosheet transistors 100-400 along with the isolation walls 119 and 129.

The patterning operation on the initial gate electrode 150 may be performed through, for example, dry etching or wet etching based on the hard mask patterns HM. The hard mask patterns HM may be formed of a material such as silicon nitride (e.g., SiN), silicon oxide (e.g., SiO₂), etc., not being limited thereto. Alternatively, an organic patterning layer (OPL) including polymer or an anti-reflective coating (ARC) layer including silicon nitride (e.g., SiN) or polymer may be formed as hard mask patterns on the top surface of the initial gate electrode 150. The material forming the initial gate electrode 150 may be Cu, W, Al, Ru, Mo, Co, and/or a combination thereof, not being limited thereto.

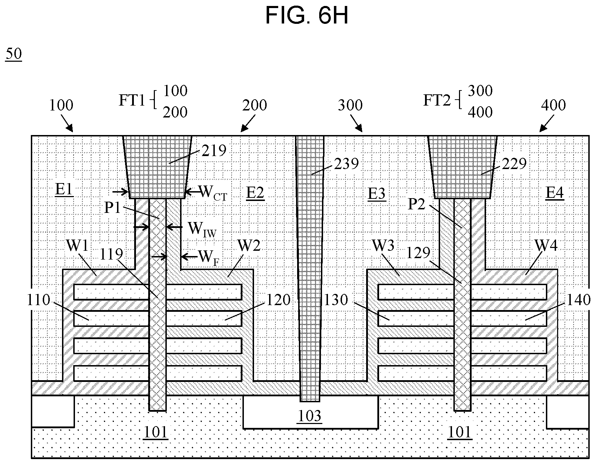

Referring to FIG. 6H, 1^{st} to 3^{rd} gate cut structures 219, 229 and 239 may be formed in the 1^{st} to 3^{rd} recesses R1-R3, respectively, to form a semiconductor device which is the same as or corresponding to the semiconductor device 50 of FIGS. 5A and 5B.

In this step, due to the increased widths W_{CT} of the 1^{st} and 2^{nd} recesses R1 and R2, the formation of the 1^{st} and 2^{nd} gate cut structures 219 and 229 therein may take advantage of a sufficiently wide alignment margin to achieve clear isolation between the gate structures 151 and 152 and isolation between the gate structures 153 and 154.

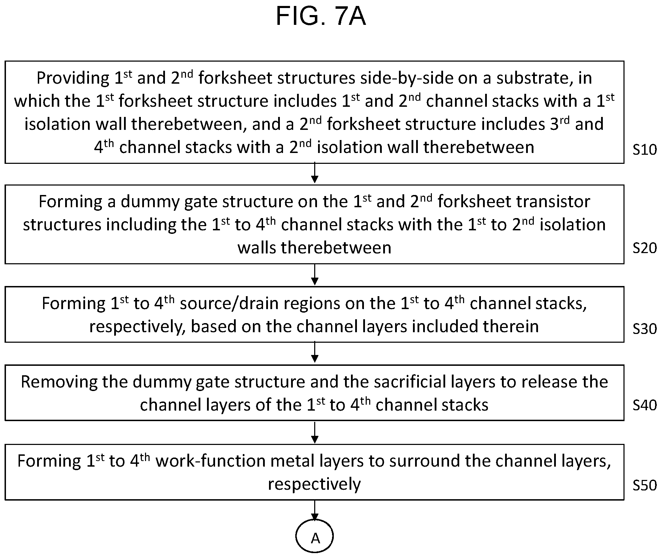

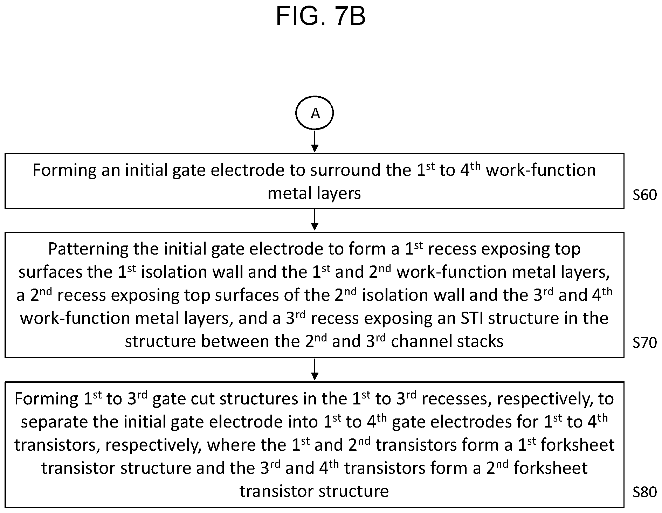

FIGS. 7A and 7B illustrate a flowchart of a method of manufacturing a semiconductor device including forksheet transistor structures including isolation walls with wide gate cut structures thereon and a field gate cut structure, according to one or more other embodiments.

In step S10, an intermediate semiconductor device including a 1^{st} forksheet transistor structure and a 2^{nd} forksheet transistor structure at a side thereof on a substrate may be provided, in which the 1^{st} forksheet transistor structure includes a 1^{st} channel stack and a 2^{nd} channel stack with a 1^{st} isolation wall therebetween, and a 2^{nd} forksheet transistor structure includes a 3^{rd} channel stack and a 4^{th} channel stack with a 2^{nd} isolation wall therebetween.

Each of the 1^{st} to 4^{th} channel stacks may include a plurality of sacrificial layers and channel layers alternatingly stacked on the substrate. The 1^{st} and 2^{nd} isolation walls may each penetrate into the substrate and includes a protruding portion formed above the 1^{st} to 4^{th} channel stacks, respectively.

In step S20, a dummy gate structure may be formed to surround the 1^{st} and 2^{nd} forksheet transistor structures including the 1^{st} to 4^{th} channel stacks with the 1^{st} to 2^{nd} isolation walls such that a top surface of the dummy gate structure is at a level above top surfaces of the 1^{st} to 2^{nd} isolation walls.

In step S30, 1^{st} to 4^{th} source/drain patterns may be formed on the 1^{st} to 4^{th} channel stacks, respectively, based on the channel layers included therein. For example, the 1^{st} to 4^{th} source/drain patterns may epitaxially grown from the channel layers and doped with p-type impurities or n-type impurities depending on the polarity of transistors to be formed of the 1^{st} to 4^{th} source/drain patterns.

In step S40, the dummy gate structure and the sacrificial layers included in the 1^{st} to 4^{th} channel stacks may be removed to release the channel layers of the 1^{st} to 4^{th} channel stacks. For example, dry etching or wet etching may be performed to etch the dummy gate structure and the sacrificial layers without attacking the channel layers.

In step S50, 1^{st} to 4^{th} work-function metal layers may be formed to surround the channel layers of the 1^{st} to 4^{th} channel stacks, respectively. At this time, upper portions of the 1^{st} and 2^{nd} work-function metal layers may be formed on side surfaces of the protruding portion of the 1^{st} isolation wall, and upper portions of the 3^{rd} and 4^{th} work-function metal layers may be formed on side surfaces of the protruding portion of the 2^{nd} isolation wall.

In step S60, an initial gate electrode may be formed on the intermediate semiconductor device obtained in the previous step such that the initial gate electrode surrounds the 1^{st} to 4^{th} work-function metal layers, and a top surface of the initial gate electrode is at a level above the top surfaces of the 1^{st} to 2^{nd} isolation walls.

In step S70, the initial gate electrode may be patterned to form a 1^{st} recess exposing top surfaces the 1^{st} isolation wall and the upper portions of the 1^{st} and 2^{nd} work-function metal layers, a 2^{nd} recess exposing top surfaces of the 2^{nd} isolation wall and the upper portions of the 3^{rd} and 4^{th} work-function metal layers, and a 3^{rd} recess exposing an STI structure in the structure between the 2^{nd} and 3^{rd} channel stacks.

In step S80, 1^{st} to 3^{rd} gate cut structures may be formed in the 1^{st} to 3^{rd} recesses, respectively, to separate the initial gate electrode into 1^{st} to 4^{th} gate electrodes for 1^{st} to 4^{th} transistors, respectively, where the 1^{st} and 2^{nd} transistors form a 1^{st} forksheet transistor structure and the 3^{rd} and 4^{th} transistors form a 2^{nd} forksheet transistor structure.

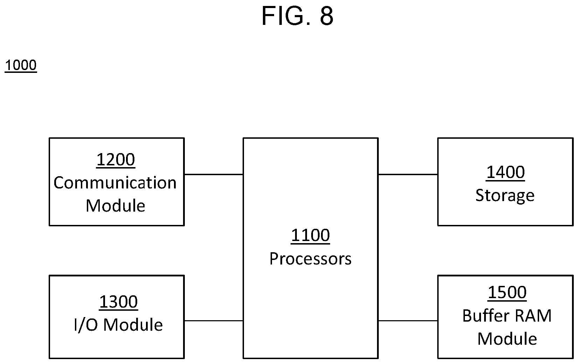

FIG. 8 is a schematic block diagram illustrating an electronic device including a semiconductor device including forksheet transistor structures including isolation walls with wide gate cut structures thereon, according to one or more embodiments. This semiconductor device may be one of the semiconductor devices shown in FIGS. 3A-3C, 4A-4B and 5A-5B.

Referring to FIG. 8, an electronic device 1000 may include at least one processor 1100, a communication module 1200, an input/output module 1300, a storage 1400, and a buffer random access memory (RAM) module 1500. The electronic device 1000 may be a mobile device such as a smartphone or a tablet computer, not being limited thereto, according to embodiments.

The processor 1100 may include a central processing unit (CPU), a graphic processing unit (GPU) and/or any other processors that control operations of the electronic device 1000. The communication module 1200 may be implemented to perform wireless or wire communications with an external device. The input/output module 1300 may include at least one of a touch sensor, a touch panel a key board, a mouse, a proximate sensor, a microphone, etc. to receive an input, and at least one of a display, a speaker, etc. to generate an output signal processed by the processor 1100. The storage 1400 may be implemented to store user data input through the input/output module 1300, the output signal, etc. The storage 1400 may be an embedded multimedia card (eMMC), a solid state drive (SSD), a universal flash storage (UFS) device, etc.

The buffer RAM module 1500 may temporarily store data used for processing operations of the electronic device 1000. For example, the buffer RAM 1500 may include a volatile memory such as double data rate (DDR) synchronous dynamic random access memory (SDRAM), low power double data rate (LPDDR) SDRAM, graphics double data rate (GDDR) SDRAM, Rambus dynamic random access memory (RDRAM), etc.

The electronic device 1000 may further include at least one sensor such as an image sensor.

At least one component in the electronic device 1000 may be formed based on a semiconductor device formed of forksheet transistor structures including isolation walls with wide gate cut structures thereon, according to one or more embodiments.

The foregoing is illustrative of example embodiments and is not to be construed as limiting the disclosure. Although a few example embodiments have been described, those skilled in the art will readily appreciate that many modifications are possible in the above embodiments without materially departing from the disclosure.

## Claims

1. A semiconductor device comprising:
a 1^{st} transistor comprising a 1^{st} channel structure extended in a 1^{st} direction, and a 1^{st} gate structure on the 1^{st} channel structure;
a 2^{nd} transistor comprising a 2^{nd} channel structure extended in the 1^{st} direction, and a 2^{nd} gate structure on the 2^{nd} channel structure, the 2^{nd} transistor being disposed adjacent to the 1^{st} transistor in a 2^{nd} direction that intersects the 1^{st} direction;
a 1^{st} isolation wall between the 1^{st} channel structure and the 2^{nd} channel structure; and
a 1^{st} gate cut structure, between the 1^{st} gate structure and the 2^{nd} gate structure, on the 1^{3t} isolation wall in a 3^{rd} direction that intersects the 1^{st} direction and the 2^{nd} direction.

2. The semiconductor device of claim 1, wherein a width of the 1^{st} gate cut structure is greater than a width of the 1^{st} isolation wall in the 2^{nd} direction.

3. The semiconductor device of claim 2, wherein the 1^{st} gate structure comprises a 1^{st} work-function metal layer on the 1^{st} channel structure and a 1^{st} gate electrode on the 1^{st} work-function metal layer, and the 2^{nd} gate structure comprises a 2^{nd} work-function metal layer on the 2^{nd} channel structure and a 2^{nd} gate electrode on the 2^{nd} work-function metal layer, and
wherein the 1^{st} gate cut structure contacts the 1^{st} isolation wall and at least one of the 1^{st} work-function metal layer and the 2^{nd} work-function metal layer.

4. The semiconductor device of claim 3, wherein the 1^{st} isolation wall comprises a protruding portion between the 1^{st} gate structure and the 2^{nd} gate structure above a level of a top surface of the 1^{st} channel structure or the 2^{nd} channel structure, and
wherein the 1^{st} gate cut structure contacts the protruding portion of the 1^{st} isolation wall and at least an upper portion of the 1^{st} work-function metal layer on a 1^{st} side surface of the protruding portion of 1^{st} isolation wall and an upper portion of the 2^{nd} work-function metal layer on a 2^{nd} side surface of the protruding portion of the 1^{st} isolation wall.

5. The semiconductor device of claim 4, wherein the width of the 1^{st} gate cut structure is greater than a sum of the width of the 1^{st} isolation wall and at least one of a width of the upper portion of the 1^{st} work-function metal layer and a width of the upper portion of the 2^{nd} work-function metal layer in the 2^{nd} direction.

6. The semiconductor device of claim 4 or 5, wherein the width of the 1^{st} gate cut structure is greater than or equal to a sum of the width of the 1^{st} isolation wall, a width of the upper portion of the 1^{st} work-function metal layer, and a width of the upper portion of the 2^{nd} work-function metal layer in the 2^{nd} direction.

7. The semiconductor device of any one of claims 1 to 6, wherein each of the 1^{st} channel structure and the 2^{nd} channel structure comprises a plurality of channel layers arranged on a substrate in the 3^{rd} direction.

8. The semiconductor device of any one of claims 1 to 7, wherein a virtual centerline of the 1^{st} gate cut structure is not aligned with a virtual center line of the 1^{st} isolation wall in the 3^{rd} direction.

9. The semiconductor device of any one of claims 1 to 8, further comprising:
a 3^{rd} transistor comprising a 3^{rd} channel structure extended in the 1^{st} direction, and a 3^{rd} gate structure on the 3^{rd} channel structure, the 3^{rd} transistor being disposed adjacent to the 2^{nd} transistor in the 2^{nd} direction;
a 4^{th} transistor comprising a 4^{th} channel structure extended in the 1^{st} direction, and a 4^{th} gate structure on the 4^{th} channel structure, the 4^{th} transistor being disposed adjacent to the 3^{rd} transistor in the 2^{nd} direction;
a 2^{nd} isolation wall between the 3^{rd} channel structure and the 4^{th} channel structure;
a 2^{nd} gate cut structure between the 3^{rd} gate structure and the 4^{th} gate structure on the 2^{nd} isolation wall in the 3^{rd} direction; and
a 3^{rd} gate cut structure between the 2^{nd} gate structure and the 3^{rd} gate structure.

10. The semiconductor device of claim 9, wherein a width of the 1^{st} gate cut structure is greater than a width of the 1^{st} isolation wall in the 2^{nd} direction, and
wherein a width of the 2^{nd} gate cut structure is greater than a width of the 2^{nd} isolation wall in the 2^{nd} direction.

11. The semiconductor device of claim 10, wherein the 3^{rd} gate structure comprises a 3^{rd} work-function metal layer on the 3^{rd} channel structure and a 3^{rd} gate electrode on the 3^{rd} work-function metal layer, and the 4^{th} gate structure comprises a 4^{th} work-function metal layer on the 4^{th} channel structure and a 4^{th} gate electrode on the 4^{th} work-function metal layer, and
wherein the 2^{nd} gate cut structure contacts the 2^{nd} isolation wall and at least one of the 3^{rd} work-function metal layer and the 4^{th} work-function metal layer.

12. The semiconductor device of any one of claims 9 to 11, wherein the 3^{rd} gate cut structure has a greater height than the 1^{st} gate cut structure or the 2^{nd} gate cut structure in the 3^{rd} direction.

13. A method of manufacture a semiconductor device, the method comprising:
providing a 1^{st} forksheet transistor structure comprising a 1^{st} channel structure and a 2^{nd} channel structure between which a 1^{st} isolation wall is disposed;
forming a 1^{st} gate structure and a 2^{nd} gate structure on the 1^{st} channel structure and the 2^{nd} channel structure, respectively; and
forming a 1^{st} gate cut structure on the 1^{st} isolation wall such that a width of the 1^{st} gate cut structure is greater than a width of the 1^{st} isolation wall.

14. The method of claim 13, wherein the 1^{st} gate structure comprises a 1^{st} work-function metal layer on the 1^{st} channel structure and a 1^{st} gate electrode on the 1^{st} work-function metal layer, and the 2^{nd} gate structure comprises a 2^{nd} work-function metal layer on the 2^{nd} channel structure and a 2^{nd} gate electrode on the 2^{nd} work-function metal layer,
wherein the 1^{st} isolation wall comprises a protruding portion between the 1^{st} gate structure and the 2^{nd} gate structure above a level of a top surface of the 1^{st} channel structure or the 2^{nd} channel structure, and
wherein the 1^{st} gate cut structure contacts the protruding portion of the 1^{st} isolation wall and at least an upper portion of the 1^{st} work-function metal layer on a 1^{st} side surface of the protruding portion of 1^{st} isolation wall and an upper portion of the 2^{nd} work-function metal layer on a 2^{nd} side surface of the protruding portion of the 1^{st} isolation wall.
